# FASCICULE DE BREVET EUROPEEN

(11) **EP 4 597 561 B1**
(45) Date de publication et mention de la délivrance du brevet: **08.04.2026**
(21) Numéro de dépôt: 25154573.7
(22) Date de dépôt: 28.01.2025
(51) Int. Cl.: H01L 21/762, H10D 30/69, H10D 62/17, H10D 86/01, H10D 84/03

(54) **PUCE ELECTRONIQUE COMPRENANT DES TRANSISTORS CONTRAINTS**
ELEKTRONISCHER CHIP MIT VERSPANNTEN TRANSISTOREN
ELECTRONIC CHIP COMPRISING STRESSED TRANSISTORS

(30) Priorité: 01.02.2024 FR 2400993
(43) Date de publication de la demande: 06.08.2025
(73) Titulaire: STMicroelectronics International N.V., 1228 Plan-les-Ouates, Genève (CH)
(72) Inventeur: BERTHELON, Remy, 38920 CROLLES (FR); WEBER, Olivier, 38000 GRENOBLE (FR)
(74) Mandataire: Cabinet Beaumont

(56) Documents cités:
- EP-A1- 3 401 953
- FR-A1- 3 109 838

## Description

### Domaine technique

La présente description concerne de façon générale le domaine des puces électroniques et vise plus particulièrement le domaine des puces électroniques comportant des transistors à région de canal contrainte, et leurs procédés de fabrication.

La présente description peut, par exemple, concerner des puces électroniques comportant en outre un circuit mémoire à changement de phase, et leurs procédés de fabrication.

### Technique antérieure

Un transistor à région de canal contrainte, ou encore transistor contraint, est un transistor à effet de champ dans lequel une région semiconductrice de formation de canal présente des contraintes mécaniques. La présence de contraintes dans la région de formation de canal (région de canal) permet d'augmenter la rapidité du transistor. On utilise généralement ce type de transistor dans des circuits numériques. FR 3109838 A1 décrit un procédé de fabrication d'une puce électronique tel que connu dans l'état de l'art.

Une mémoire à changement de phase est un type de mémoire dans lequel un matériau à changement de phase peut prendre deux états, typiquement des états cristallin et amorphe, correspondant chacun à une valeur de bit mémorisée. Typiquement, la mémoire est constituée de points mémoire à changement de phase stockant chacun la valeur d'un bit.

Il existe un besoin d'amélioration des puces électroniques comprenant des transistors à région de canal contrainte, et dans certains cas également un circuit mémoire à changement de phase, ainsi que les procédés de fabrication de telles puces électroniques.

En particulier, il existe un besoin d'améliorer, ou de ne pas relâcher, les contraintes dans les transistors à région de canal contrainte, notamment au cours du procédé de fabrication des puces électroniques. Il existe un besoin d'améliorer les performances des transistors à région de canal contrainte des puces électroniques.

### Résumé de l'invention

Un mode de réalisation pallie tout ou partie des inconvénients des puces électroniques connues.

Un mode de réalisation pallie tout ou partie des inconvénients des procédés connus de fabrication de puces électroniques.

Un mode de réalisation prévoit un procédé de fabrication d'une puce électronique, le procédé comprenant les étapes successives consistant à :
- prévoir une couche semiconductrice située sur un isolant recouvrant un substrat semiconducteur ;
- oxyder des premières et deuxièmes portions de la couche semiconductrice jusqu'à l'isolant, de manière à former des premières portions oxydées et des deuxièmes portions oxydées sur l'isolant ;
- générer des contraintes dans une troisième portion de la couche semiconductrice non traversée par les premières et deuxièmes portions oxydées, la troisième portion s'étendant de manière continue entre les deuxièmes portions oxydées ;
- former des cavités s'étendant au moins jusqu'au substrat semiconducteur à travers les deuxièmes portions oxydées et l'isolant ; et
- former des premiers transistors à effet de champ dans et sur la troisième portion.

Un mode de réalisation prévoit une puce électronique comprenant :
- des premières, deuxièmes et troisième portions d'une couche semiconductrice située sur un isolant recouvrant un substrat semiconducteur, les premières et deuxièmes portions de ladite couche semiconductrice étant oxydées jusqu'à l'isolant, la troisième portion étant contrainte, n'étant pas traversée par les premières et deuxièmes portions oxydées, et s'étendant de manière continue entre des premières parties des deuxièmes portions oxydées ;
- des cavités s'étendant au moins jusqu'au substrat semiconducteur à travers les deuxièmes portions oxydées et l'isolant ; et
- des premiers transistors à effet de champ situés dans et sur la troisième portion.

Selon un mode de réalisation, des quatrièmes portions de la couche semiconductrice sont formées à côté de la troisième portion, chaque quatrième portion étant entre deux des premières portions oxydées ou entre une des premières portions oxydées et une des deuxièmes portions oxydées ; et
- des deuxièmes transistors à effet de champ sont formés dans et sur les quatrièmes portions.

Selon un mode de réalisation, des premières grilles sont formées au-dessus des troisième et quatrièmes portions.

Selon un mode de réalisation, des deuxièmes grilles sont formées au-dessus des premières portions oxydées et des grilles d'isolation sont formées dans la prolongation des deuxièmes grilles au-dessus de la troisième portion.

Selon un mode de réalisation, les quatrièmes portions sont positionnées à côté de la troisième portion dans la direction de la largeur des transistors à effet de champ.

Selon un mode de réalisation, les premiers transistors sont à canal P contraint, et les deuxièmes transistors sont à canal N, par exemple à canal N non contraint.

Selon un mode de réalisation, des tranchées isolantes s'étendent à travers la couche semiconductrice et l'isolant jusqu'à un niveau situé à l'intérieur du substrat semiconducteur, les tranchées isolantes comprenant une première tranchée isolante entre la troisième portion et les quatrièmes portions.

Selon un mode de réalisation, la contrainte de la troisième portion résulte d'une modification de la composition de la couche semiconductrice dans ladite troisième portion, par exemple comprend la formation d'une couche de silicium-germanium sur la troisième portion, suivie d'un traitement thermique.

Selon des modes de réalisation :
- les premières portions oxydées sont sensiblement parallèles entre elles, par exemple parallèles à la direction de la largeur des transistors à effet de champ ; et/ou
- les deuxièmes portions oxydées sont sensiblement parallèles entre elles, par exemple parallèles à la direction de la largeur des transistors à effet de champ ; et/ou
- les premières portions oxydées sont positionnées entre au moins deux des deuxièmes portions oxydées.

Selon un mode de réalisation, la couche semiconductrice est une couche de silicium.

Selon un mode de réalisation, les premiers transistors sont de type FDSOI.

Selon un mode de réalisation, des transistors bipolaires sont formés dans au moins une première partie des cavités, et des points mémoire à changement de phase reliés aux transistors bipolaires sont formés.

Selon un mode de réalisation, des zones semiconductrices dopées d'émetteur, de base et de collecteur des transistors bipolaires sont formées dans des premières portions semiconductrices épitaxiées dans la au moins une première partie des cavités.

Selon un mode de réalisation, des troisièmes grilles sont formées sur des deuxièmes parties des deuxièmes portions oxydées entre les transistors bipolaires.

Selon un mode de réalisation, des transistors à effet de champ supplémentaires sont formés dans et sur des deuxièmes portions semiconductrices épitaxiées dans une deuxième partie des cavités.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A représente, par des vues partielles et schématiques de dessus et en coupe, une structure obtenue à une étape d'un mode de réalisation d'un procédé de fabrication d'une puce électronique ;
la figure 1B représente deux vues en coupe partielles et schématiques de la structure de la figure 1A ;
la figure 2A représente, par des vues partielles et schématiques de dessus et en coupe, une structure obtenue à une autre étape du procédé de fabrication ;
la figure 2B représente deux vues en coupe partielles et schématiques de la structure de la figure 2A ;
la figure 3A représente, par des vues partielles et schématiques de dessus et en coupe, une structure obtenue à une autre étape du procédé de fabrication ;
la figure 3B représente deux vues en coupe partielles et schématiques de la structure de la figure 3A ;
la figure 4A représente, par des vues partielles et schématiques de dessus et en coupe, une structure obtenue à une autre étape du procédé de fabrication ;
la figure 4B représente deux vues en coupe partielles et schématiques de la structure de la figure 4A ;
la figure 5A représente, par des vues partielles et schématiques de dessus et en coupe, une structure obtenue à une autre étape du procédé de fabrication ;
la figure 5B représente deux vues en coupe partielles et schématiques de la structure de la figure 5A ;
la figure 6A représente, par des vues partielles et schématiques de dessus et en coupe, une structure obtenue à une autre étape du procédé de fabrication ; et
la figure 6B représente deux vues en coupes partielles et schématiques de la structure de la figure 6A.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, des étapes de fabrication de points mémoire à changement de phase ne sont pas décrites en détails, les modes de réalisation décrits étant compatibles avec les étapes usuelles de fabrication de points mémoire à changement de phase. Similairement, des étapes de fabrication de transistors bipolaires ou à effet de champ ne sont pas décrites en détails, les modes de réalisation décrits étant compatibles avec les étapes usuelles de fabrication de transistors bipolaires ou à effet de champ.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des vues en coupe.

Sauf précision contraire, les expressions "environ", "approximativement", "sensiblement", et "de l'ordre de" signifient à 10 % ou à 10° près, de préférence à 5 % ou à 5° près.

Sauf précision contraire, les adjectifs numéraux ordinaux, tels que "premier", "deuxième", etc., sont utilisés seulement pour distinguer des éléments entre eux. En particulier, ces adjectifs ne limitent pas les dispositifs et procédés décrits à un ordre particulier de ces éléments.

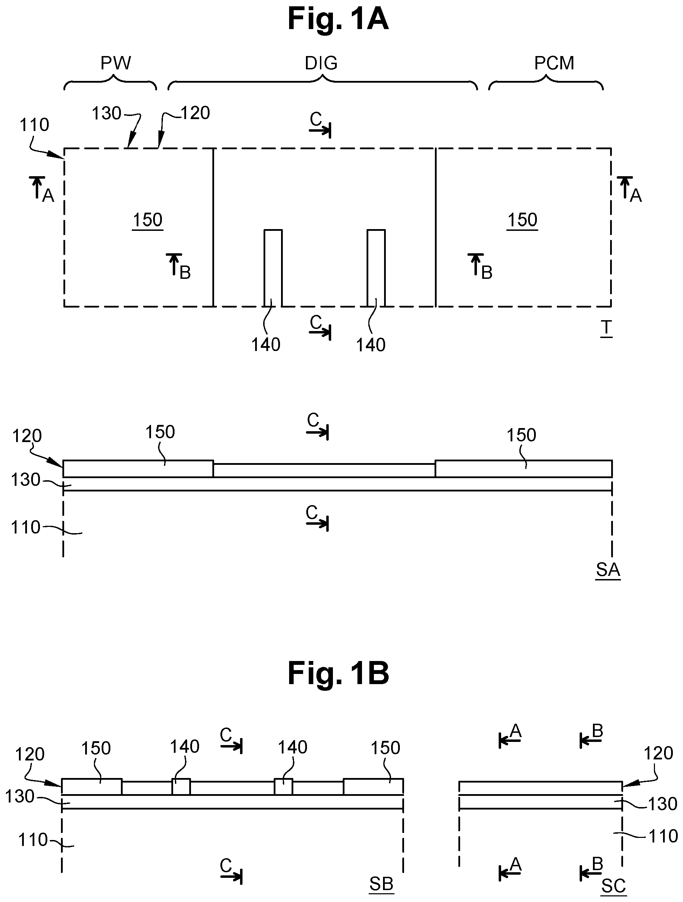

Les figures 1A, 2A, 3A, 4A, 5A et 6A représentent chacune, par des vues partielles et schématiques de dessus T et en coupe SA selon un plan A-A, une structure obtenue à une étape d'un mode de réalisation d'un procédé de fabrication d'une puce électronique. Les vues T et SA sont en correspondance.

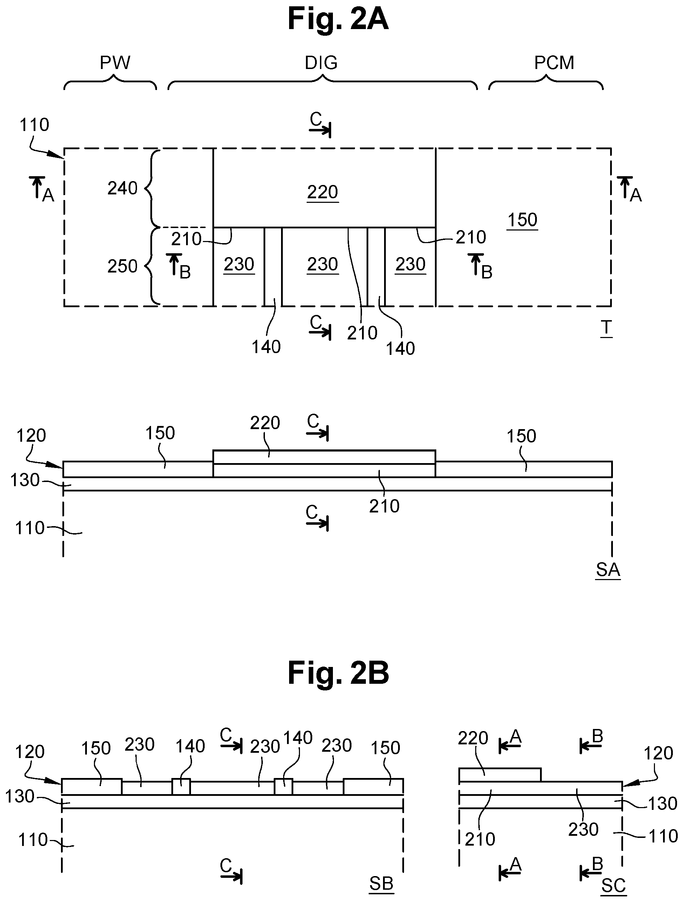

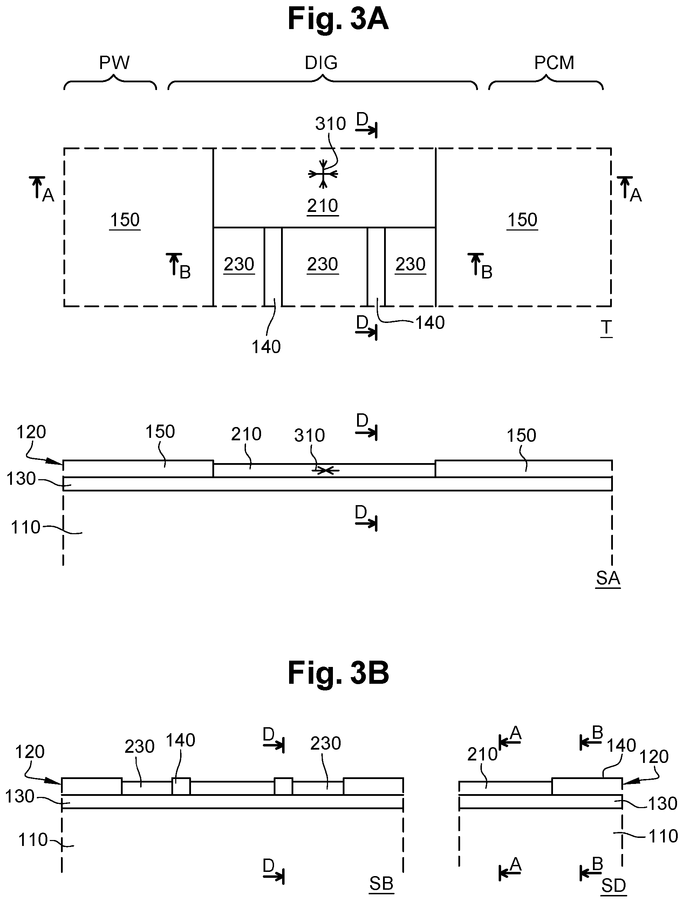

Les figures 1B, 2B, 3B, 4B, 5B et 6B représentent chacune deux vues en coupe partielles et schématiques des structures respectives des figures 1A, 2A, 3A, 4A, 5A et 6A. Chacune des figures 1B et 2B représente une vue en coupe SB selon un plan B-B parallèle au plan A-A et une vue en coupe SC selon un plan C-C orthogonal aux plans A-A et B-B. Les vues SB et SC sont en correspondance. Chacune des figures 3B, 4B, 5B et 6B représente une vue en coupe SB selon le plan B-B et une vue en coupe SD selon un plan D-D parallèle au plan C-C. Les vues SB et SD sont en correspondance.

Par puce électronique, ou puce, on entend une portion de substrat semiconducteur 110 ou tranche semiconductrice (en anglais "wafer"), et des circuits électroniques situés dans et sur le substrat semiconducteur 110. La puce obtenue à l'issue du procédé ci-après comprendra, dans une partie DIG (partie numérique) de la puce, un ou des circuits numériques comprenant des transistors contraints, et dans une partie PCM de la puce, une mémoire à changement de phase (en anglais "Phase Change Memory"). De préférence, une partie PW de la puce comprendra d'autres transistors. Ces autres transistors pourront être utilisés dans des circuits d'alimentation destinés à fournir une tension aux circuits numériques de la puce, à partir d'une tension d'alimentation appliquée à la puce pour la faire fonctionner.

Bien que les parties DIG, PCM et l'éventuelle partie PW soient juxtaposées dans l'exemple représenté, ces parties peuvent être séparées dans d'autres exemples. Dans encore d'autres exemples, la puce peut comprendre plusieurs parties DIG et/ou plusieurs parties PCM et/ou plusieurs parties PW.

A l'étape des figures 1A et 1B, on prévoit une couche semiconductrice 120 située sur un isolant électrique 130 (ou diélectrique) recouvrant le substrat 110. La couche semiconductrice 120, l'isolant 130 et le substrat semiconducteur 110 peuvent ainsi constituer une structure dite silicium sur isolant, SOI (de l'anglais "Silicon On Insulator").

De préférence, la couche semiconductrice 120 est une couche de silicium, et l'isolant 130 est une couche d'oxyde de silicium. Le substrat 110 peut être une portion de tranche de silicium. A titre d'exemple, la couche semiconductrice 120 a une épaisseur comprise entre 3 nm et 10 nm.

On a oxydé des premières et deuxièmes portions, respectivement 140 et 150, de la couche semiconductrice 120, formant des premières portions oxydées 140 et des deuxièmes portions oxydées 150. Plus précisément, les premières et deuxièmes portions de la couche semiconductrice 120 sont oxydées sur toute l'épaisseur de la couche semiconductrice 120. Pour cela, on peut utiliser toute étape usuelle d'oxydation d'une couche semiconductrice, typiquement une oxydation thermique. Cette étape, étant usuelle, n'est pas décrite ici en détail. Notamment, un masque protégeant de l'oxydation des portions de la couche semiconductrice 120 que l'on ne souhaite pas oxyder à cette étape n'est pas représenté. Du fait de l'oxydation, les portions oxydées ont une épaisseur supérieure à l'épaisseur de la couche semiconductrice 120.

Les premières portions oxydées 140 peuvent être situées dans la partie numérique DIG de la future puce. De préférence, les premières portions oxydées 140 ont une direction d'allongement dans la largeur, correspondant à la direction de la coupe C-C. Les premières portions oxydées 140 forment alors des barres d'oxyde parallèles entre elles, pouvant avoir une fonction d'isolation électrique. Les premières portions oxydées 140 ne s'étendent pas sur toute la largeur de la couche semiconductrice 120. Les premières portions oxydées 140 ne s'étendent pas dans une future portion contrainte de la couche semiconductrice 120. Ainsi, dans l'exemple représenté, on voit dans la vue T de la figure 1A les premières portions oxydées 140 dans la moitié inférieure, mais pas dans la moitié supérieure, et on voit les premières portions oxydées 140 dans la vue SB de la figure 1B, mais pas dans la vue SA de la figure 1A, la coupe A-A étant réalisée dans une région où il n'y a pas de premières portions oxydées. Bien que deux premières portions oxydées 140 soient formées dans l'exemple représenté, de préférence, on oxyde plus de deux premières portions 140.

Les deuxièmes portions oxydées 150 peuvent être situées en partie dans la partie PCM destinée à contenir la mémoire à changement de phase. Dans l'exemple où une partie PW est prévue, les deuxièmes portions oxydées 150 peuvent être situées au moins en partie dans la partie PCM et dans la partie PW.

De préférence, dans la partie PCM et, éventuellement, la partie PW, l'intégralité de la couche semiconductrice 120 est oxydée. Autrement dit, les deuxièmes portions oxydées 150 occupent l'intégralité des parties PCM et éventuellement PW.

Des deuxièmes portions oxydées 150 peuvent également être prévues dans la partie DIG, par exemple sur deux côtés opposés de la partie DIG. Dans l'exemple représenté, les deuxièmes portions oxydées 150 couvrent l'intégralité des parties PCM et PW et se prolongent sur la partie DIG.

Les premières portions oxydées 140 peuvent être positionnées entre les deuxièmes portions oxydées 150.

Les premières et deuxièmes portions oxydées peuvent former des tranchées d'isolation très peu profondes (SSTI, de l'anglais "Super Shallow Trench Isolation"), pour isoler de futurs transistors entre eux.

A l'étape des figures 2A et 2B, on a formé du silicium-germanium 220 par épitaxie sur une troisième portion 210 non oxydée de la couche semiconductrice 120. La troisième portion 210 est incluse dans, par exemple correspond à, la région de la couche semiconductrice qui ne comporte pas de premières portions oxydées 140.

Plus précisément, l'épitaxie est réalisée du côté de la face supérieure de la structure (dans l'orientation des vues en coupe), dite aussi face avant, qui correspond à la face supérieure de la couche semiconductrice 120. A titre d'exemple, l'épaisseur du silicium-germanium épitaxié 220 est comprise entre 5 et 20 nm.

La troisième portion 210 s'étend entre les deuxièmes portions oxydées 150, c'est-à-dire s'étend à partir de l'une des deuxièmes portions oxydées 150 jusqu'à une autre des deuxièmes portions oxydées 150. Autrement dit, la troisième portion 210 est délimitée, sur chacun de deux côtés opposés par une des deuxièmes portions oxydées 150. En outre, la troisième portion 210 s'étend de manière continue entre les deuxièmes portions oxydées 150. Par continue, on entend que la troisième portion n'est pas traversée par des premières portions oxydées.

La troisième portion 210 est située, en vue de dessus, dans une première bande 240. Une autre troisième portion, non représentée, peut être située dans une autre bande parallèle à la première bande 240. D'autres troisièmes portions peuvent être situées chacune dans une autre bande parallèle à la première bande 240.

Lors de l'épitaxie, un désaccord entre mailles cristallines provoque, dans le silicium-germanium épitaxié 220, des contraintes de compression parallèles à la face avant (c'est-à-dire horizontales dans l'orientation des vues en coupe) .

De préférence, à côté de la troisième portion 210, par exemple à côté dans la largeur, la couche semiconductrice 120 comprend des quatrièmes portions 230 non oxydées et non recouvertes de silicium-germanium épitaxié. Les quatrièmes portions 230 sont incluses dans, par exemple correspondent à, une région de la couche semiconductrice traversée par les premières portions oxydées 140.

Chaque quatrième portion 230 s'étend entre certaines des premières et deuxièmes portions oxydées, c'est-à-dire s'étend à partir de l'une des premières et deuxièmes portions oxydées 140 et 150 jusqu'à une autre des premières et deuxièmes portions oxydées 140 et 150. Autrement dit, chacune des quatrièmes portions 230 est délimitée, sur deux côtés opposés, par deux portions parmi les premières et deuxièmes portions oxydées 140 et 150. Les quatrièmes portions 230 sont situées, en vue de dessus, dans une deuxième bande 250 parallèle à la première bande 240. Les première et deuxième bandes 240 et 250 sont situées côte à côte, par exemple côte à côte dans la largeur. La deuxième bande 250 est sensiblement perpendiculaire aux premières portions oxydées 140. D'autres quatrièmes portions, non représentées, peuvent être situées dans une autre bande parallèle à la deuxième bande 250. D'autres quatrièmes portions peuvent être situées dans d'autres bandes parallèles à la deuxième bande 250.

Les quatrièmes portions 230, non destinées à être recouvertes de silicium-germanium épitaxié, peuvent être recouvertes, au cours de l'épitaxie, de tout masque usuel adapté à protéger au moins ces quatrièmes portions, par exemple un masque adapté à protéger des régions de la couche semiconductrice 120 comprenant les premières et deuxièmes portions oxydées 140, 150 et les quatrièmes portions 230 en laissant découverte la troisième portion 210, pour que le silicium-germanium épitaxié croisse à partir de la troisième portion mais ne croisse pas à partir des quatrièmes portions.

A l'étape des figures 3A et 3B, on a effectué un traitement thermique, de manière à oxyder le silicium-germanium épitaxié. Généralement, les régions qui ne doivent pas être traitées sont protégées par une couche de protection, par exemple une couche en nitrure de silicium (SiN). Le silicium du silicium-germanium 220 s'oxyde préférentiellement, et le germanium du silicium-germanium 220 migre vers la troisième portion 210 de la couche semiconductrice 120. Il en résulte une intensification et un transfert dans la troisième portion 210 des contraintes initialement présentes dans le silicium-germanium 220.

Il en résulte que des contraintes 310 de compression ont été générées dans la troisième portion 210. Les contraintes de compression 310 sont dans les deux directions horizontales (dans l'orientation des vues en coupe). Pour générer les contraintes 310, on a modifié la composition de la troisième portion 210. Autrement dit, la troisième portion 210 acquiert une composition différente des quatrièmes portions 230, à savoir, de préférence, la troisième portion 210 est en silicium-germanium, et les quatrièmes portions 230 sont en silicium.

Le fait que la troisième portion 210 n'est pas traversée par les premières portions oxydées 140 permet d'éviter un relâchement des contraintes 310, relâchement qui pourrait se produire si les premières portions oxydées traversaient la troisième portion. En outre, si les premières portions oxydées étaient présentes au sein de la troisième portion, tout ou partie de l'oxyde de ces premières portions pourraient être consommées lors de l'épitaxie de silicium-germanium et lors du retrait de la couche d'oxyde de silicium obtenue par le traitement thermique, ce qui annulerait au moins en partie la fonction d'isolation de ces premières portions.

De préférence, on nettoie ensuite la face avant de la structure, en sorte de retirer ce qui reste de la couche d'oxyde de silicium obtenue lors du traitement thermique.

L'exemple particulier décrit ci-dessus de génération de contraintes dans la troisième portion 210 n'est pas limitatif. Les modes de réalisation décrits sont compatibles avec les procédés usuels de génération de contraintes dans une ou plusieurs portions d'une couche semiconductrice.

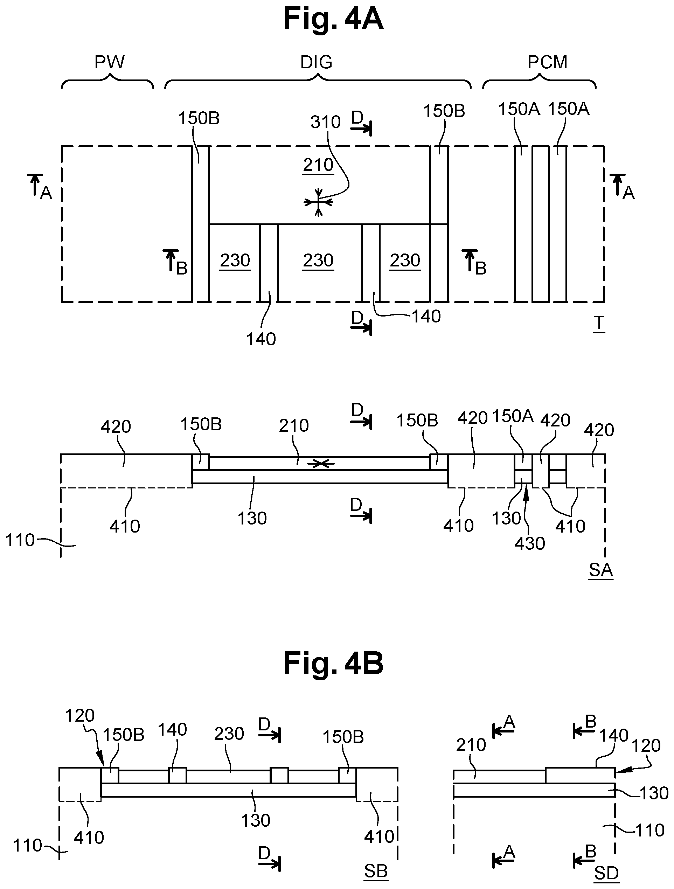

A l'étape des figures 4A et 4B, on grave, à partir de la face avant de la couche semiconductrice 120, en particulier des faces avant des deuxièmes portions oxydées 150, des cavités 410 s'étendant au moins jusqu'au substrat 110 à travers les deuxièmes portions oxydées 150 et l'isolant 130. Les cavités 410 atteignent le substrat 110 et peuvent pénétrer dans le substrat 110.

De préférence, dans la partie PCM destinée à comprendre la future mémoire à changement de phase, on laisse en place des empilements 430 de parties 130A de l'isolant 130 et de parties 150A (deuxièmes parties) des deuxièmes portions oxydées 150. Les cavités 410 délimitent les empilements 430.

Bien que seuls deux empilements 430 soient prévus dans l'exemple représenté, le nombre des empilements 430 est, de préférence, supérieur à deux. De préférence, les empilements 430 ont, en vue de dessus, des formes de bandes parallèles aux premières portions oxydées 140. Les empilements 430 forment alors des barres électriquement isolantes.

De préférence, dans la partie DIG destinée à comprendre les futurs transistors contraints, on laisse également en place contre la troisième portion 210 et les quatrièmes portions 230, des parties 150B (premières parties) des deuxièmes portions oxydées 150. En d'autres termes, les troisième et les quatrièmes portions 210 et 230 sont délimitées dans la longueur, correspondant à la direction des coupes A-A et B-B, par les parties 150B des deuxièmes portions oxydées 150.

On a formé ensuite, par épitaxie, un semiconducteur dans les cavités 410. Le semiconducteur épitaxié est typiquement le même que celui du substrat 110, à savoir, préférentiellement, du silicium. Chaque cavité 410 est remplie par une portion semiconductrice épitaxiée 420. De préférence, les portions semiconductrices épitaxiées 420 atteignent un niveau situé au-dessus (dans l'orientation des vues en coupe) du niveau supérieur de la troisième portion 210 et du niveau supérieur des quatrièmes portions 230. Autrement dit, les portions semiconductrices épitaxiées 420 dépassent les niveaux des faces avant des troisième et quatrièmes portions 210 et 230. Dans la partie PCM, les portions semiconductrices épitaxiées 420 sont isolées électriquement les unes des autres par les empilements 430.

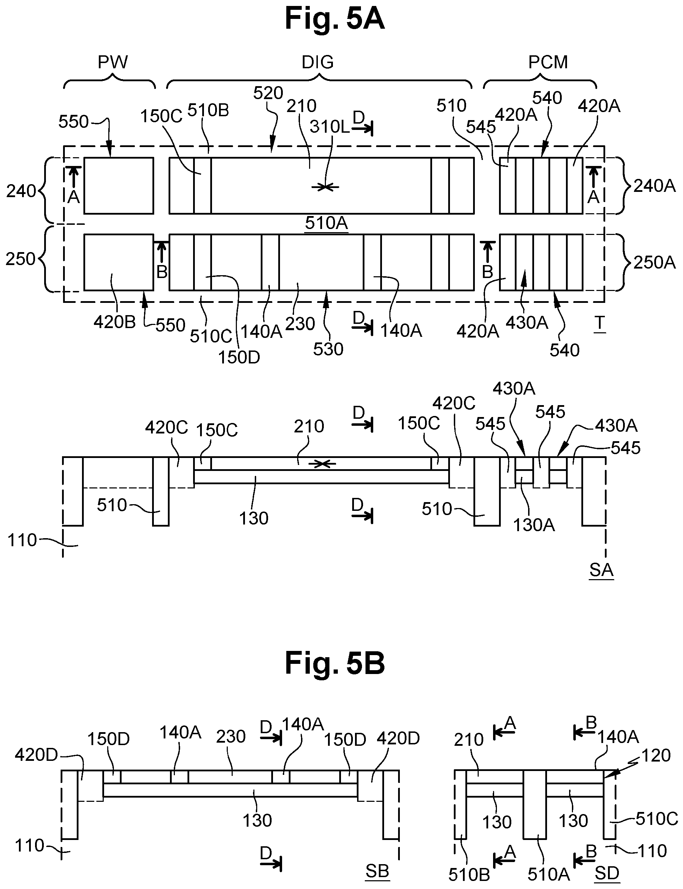

A l'étape des figures 5A et 5B, de préférence, on a retiré tous les éléments de la structure des figures 4A et 4B situés au-dessus du niveau de la face supérieure des quatrièmes portions 230. Pour cela, on peut mettre en œuvre une étape usuelle de polissage mécano-chimique.

De préférence, on a formé des tranchées isolantes 510 c'est-à-dire des tranchées remplies d'un isolant électrique, de préférence de l'oxyde de silicium. Autrement dit, on met en œuvre successivement une étape de gravure des tranchées, suivie d'une étape de remplissage par l'isolant électrique. Ces étapes ne sont pas décrites ici en détail, les modes de réalisation décrits étant compatibles avec les étapes usuelles de gravure et de remplissage pour former des tranchées isolantes. Les tranchées isolantes peuvent former des tranchées d'isolation peu profondes (STI, de l'anglais " Shallow Trench Isolation"). De préférence, les tranchées isolantes 510 séparent les unes des autres les parties DIG et PCM, et les parties DIG et PW.

Les tranchées isolantes 510 s'étendent à partir de la face avant de la couche semiconductrice 120, passent par le niveau occupé par les premières, deuxièmes, troisième et quatrièmes portions 140, 150, 210, 230 de la couche semiconductrice 120, et à travers l'isolant 130, jusqu'à un niveau situé à l'intérieur du substrat 110.

Les emplacements des tranchées isolantes 510 sont choisis de telle sorte que les tranchées isolantes 510 entourent (en vue de dessus) des régions de la puce. La gravure des tranchées isolantes 510 laisse en place une partie centrale de chacune des troisième et quatrièmes portions 210 et 230, autrement dit, les tranchées isolantes 510 réduisent les dimensions des troisième et quatrièmes portions. La gravure laisse en place des parties 140A des premières portions oxydées 140 et des parties 430A des empilements 430.

Parmi les régions de la puce entourées par les tranchées isolantes 510, une ou plusieurs régions 540 situées dans la partie PCM comprennent des portions semiconductrices 420A (premières portions semiconductrices épitaxiées) constituées par une partie des portions semiconductrices épitaxiées 420. On forme des zones semiconductrices dopées respectivement d'émetteur, de base et de collecteur (non représentées en détail) d'un transistor bipolaire 545 dans chacune des portions semiconductrices 420A. Ces zones peuvent être formées par dopage au cours de l'épitaxie, ou, de préférence, par dopage des portions semiconductrices 420A. Les transistors bipolaires 545 sont par exemple de type NPN. Les zones dopées des transistors bipolaires 545 sont isolées entre elles par les parties 430A des empilements 430.

Parmi les régions entourées par les tranchées isolantes 510, une région 520 située dans la partie DIG comprend la partie centrale de la troisième portion 210. De préférence, la région 520 comprend une ou plusieurs portions semiconductrices 420C constituées par une partie des portions semiconductrices épitaxiées 420. Les portions semiconductrices 420C de la région 520 sont isolées électriquement de la troisième portion 210 par des parties 150C des deuxièmes portions oxydées 150. Les parties 150C correspondent aux parties 150B des deuxièmes portions oxydées 150 qui sont restées en place dans la région 520 après formation des tranchées isolantes 510.

Parmi les régions entourées par les tranchées isolantes 510, une région 530 située dans la partie DIG comprend les parties 140A des premières portions oxydées 140 et la partie centrale des quatrièmes portions 230. De préférence, la région 530 comprend une ou plusieurs portions semiconductrices 420D constituées par une partie des portions semiconductrices épitaxiées 420. Les portions semiconductrices 420D de la région 530 sont isolées des quatrièmes portions 230 par des parties 150D des deuxièmes portions oxydées 150. Les parties 150D correspondent aux parties 150B des deuxièmes portions oxydées 150 qui sont restées en place dans la région 530 après formation des tranchées isolantes 510.

De préférence, parmi les tranchées isolantes 510, une tranchée isolante 510A s'étend, en vue de dessus, parallèlement aux première et deuxième bandes 240 et 250 et à cheval sur les bandes 240 et 250. La tranchée isolante 510A est ainsi située à cheval sur les emplacements de la troisième portions 210 et des quatrièmes portions 230, ou entre les parties centrales des troisième et quatrièmes portions.

Les tranchées isolantes 510 sont de préférence formées après génération des contraintes 310. Il en résulte que la troisième portion 210 peut s'allonger dans la tranchée isolante 510A avant remplissage des tranchées par l'isolant, ce qui relâche les contraintes 310 dans la direction orthogonale à la première bande 240. Cependant, du fait de l'absence des premières portions oxydées 140 dans la troisième portion 210, comme expliqué plus avant, on a évité avantageusement que les contraintes dans la direction de la première bande 240 soient relâchées.

Ainsi, après formation des tranchées isolantes 510, 510A, la troisième portion 210 présente des contraintes de compression 310L dans la direction longitudinale de la première bande 240, et ne sont sensiblement pas contraintes dans la direction transversale de la première bande 240.

De préférence, parmi les tranchées isolantes 510, une tranchée isolante 510B est située par rapport à la troisième portion 210 du côté opposé à la tranchée isolante 510A, s'étend parallèlement à la première bande 240 et délimite la troisième portion 210. Ainsi, la région 520 est située dans une partie centrale 240A de la première bande 240.

De préférence, parmi les tranchées isolantes 510, une tranchée isolante 510C, est située par rapport aux quatrièmes portions 230 du côté opposé à la tranchée isolante 510A, s'étend parallèlement à la deuxième bande 250 et délimite les quatrièmes portions 230. Ainsi, la région 530 est située dans une partie centrale 250A de la deuxième bande 250.

De préférence, parmi les régions de la puce entourées par les tranchées isolantes 510, une région 550 située dans la partie PW comprend des portions semiconductrices 420B (deuxièmes portions semiconductrices épitaxiées) constituées par une partie des portions semiconductrices épitaxiées 420.

Dans l'exemple représenté, les tranchées isolantes 510A, 510B et 510C, qui s'étendent parallèlement aux parties centrales 240A, 250A des première et deuxième bandes 240, 250, se prolongent dans les parties PCM et PW. Il en résulte que la partie PCM comprend une région 540 dans chacune des parties centrales 240A, 250A, et que la partie PW comprend une région 550 dans chacune des parties centrales 240A, 250A.

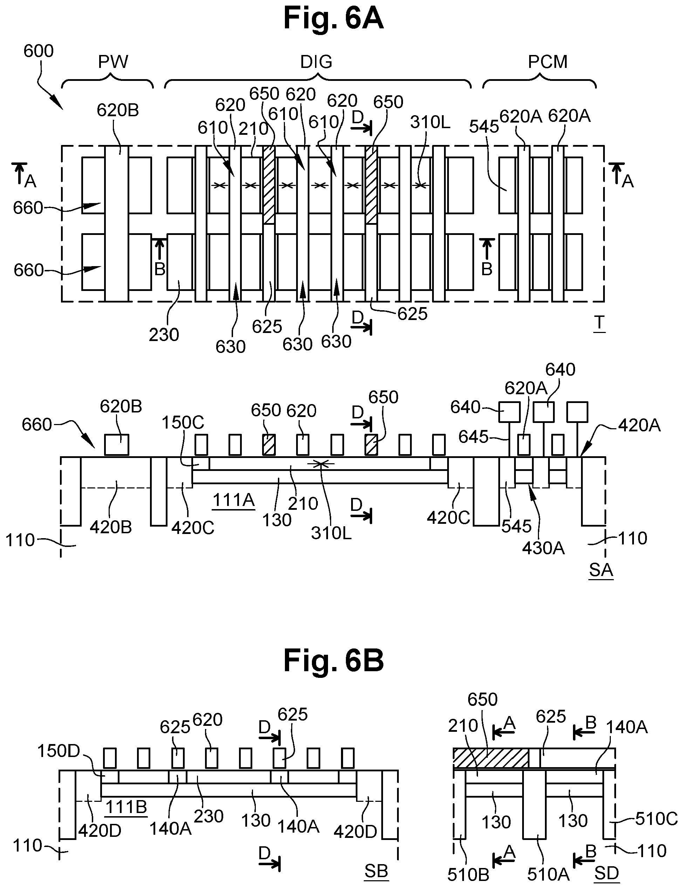

A l'étape des figures 6A et 6B, on forme des transistors à effet de champ 610 dans et sur la troisième portion 210. Plus précisément, on forme sur la troisième portion 210 des grilles 620 (premières grilles), de préférence allongées orthogonalement à la direction de la première bande 240. Comme il n'y a pas de premières parties oxydées 140 au sein de la troisième portion 210, la troisième portion peut former une zone active continue ("continuous RX" en anglais). Les transistors 610 peuvent alors être isolés entre eux par des grilles d'isolation 650 ("gate-tie", ou "tying gate" en anglais) positionnées au-dessus de la troisième portion et dans le prolongement des premières parties oxydées 140 dans la direction de la largeur. Entre deux grilles d'isolation 650, la troisième portion 210 peut comprendre plusieurs transistors 610, par exemple des transistors ayant une borne de drain-source commune. De préférence, les grilles 620, 650 sont régulièrement espacées, c'est-à-dire que sensiblement un même espace peut être compris entre deux grilles 620 ou entre une grille 620 et une grille d'isolation 650.

Les parties de la troisième portion 210 situées sous les grilles 620 constituent des régions de formation de canal des transistors 610. Du fait de la présence des contraintes 310L, les transistors 610 sont des transistors contraints. De préférence, les parties de la troisième portion 210 situées de part et d'autre des régions de formation de canal sont dopées de type P pour former des régions de drain et de source des transistors 610. Les transistors 610 sont ainsi des transistors à canal P (PMOS). Dans la région de formation de canal, la présence de contraintes de compression dans la direction drain-source (direction de longueur des transistors) et, sensiblement, l'absence de contrainte dans la direction de largeur des transistors, permet d'obtenir des transistors 610 à canal P particulièrement rapides.

De préférence, les grilles 620 s'étendent également au-dessus des quatrièmes portions 230.

De préférence, on forme des transistors à effet de champ 630 dans et sur les quatrièmes portions 230. Plus précisément, les parties des quatrièmes portions 230 situées sous les grilles 620 constituent des régions de formation de canal des transistors 630. Les transistors 630 peuvent être isolés entre eux par les premières portions oxydées 140 qui peuvent former des tranchées d'isolation très peu profondes (SSTI). En outre, des grilles 625 (deuxièmes grilles) sont formées au-dessus des premières portions oxydées 140 entre les quatrièmes portions 230. Ainsi, les grilles d'isolation 650 sont positionnées dans le prolongement des grilles 625 dans la direction de la largeur, mais sont de préférence séparées des grilles 625 par un espace. De préférence, les parties des quatrièmes portions 230 situées de part et d'autre des régions de formation de canal sont dopées de type N pour former des régions de drain et de source des transistors 630. Les transistors 630 sont ainsi des transistors à canal N (NMOS), et permettent de former, avec les transistors à canal P 610, des circuits numériques. Les transistors 630 ne sont pas des transistors à région de formation de canal contrainte.

De préférence, les transistors 610 et 630 sont du type SOI complètement déserté, ou FDSOI (en anglais "Fully Depleted SOI"). Par transistor FDSOI, on entend ici que l'épaisseur de leur région de formation de canal est inférieure à 10 nm.

Les autres éléments des transistors à effet de champ ne sont pas décrits, les modes de réalisation décrits étant compatibles avec les procédés usuels de formation de transistors à effet de champ sur une portion d'une couche semiconductrice. En particulier, on pourra prévoir que des zones conductrices en contact électrique avec les régions de drain et de source, c'est-à-dire des zones de contact ou prises de contact, soient formées, par exemple épitaxiées, sur la troisième portion 210 et sur les quatrième portions 230, au moins de part et d'autre des grilles 620. En outre, de préférence, les grilles sont isolées de la couche semiconductrice 120 par un isolant de grille.

De préférence, dans la partie PCM, on a formé des points mémoire 640 à changement de phase. Les points mémoire 640 sont par exemple situés dans des couches isolantes, non représentées, recouvrant la structure. Chaque point mémoire est relié, de préférence connecté, à l'un des transistors bipolaires 545. Plus précisément, le point mémoire 640 et le transistor bipolaire 545 sont électriquement en série. Pour chaque point mémoire 640, un via 645 peut connecter le point mémoire 640 et le transistor 545 bipolaire associé.

Dans la puce en fonctionnement, lors d'une étape d'écriture et/ou ou de lecture de la mémoire à changement de phase, le ou les points mémoires 640 concernés par l'écriture ou la lecture sont sélectionnés en rendant passants le ou les transistors bipolaires 545 en série avec ce ou ces points mémoire 640. Les transistors bipolaires 545 sont ainsi dénommés transistors de sélection.

Dans la puce 600 obtenue par le procédé ci-dessus, les isolations électriques entre les transistors NMOS 630, constituées par les parties 140A des premières portions oxydées 140, et les isolations électriques entre les transistors bipolaires 545 de sélection de la mémoire à changement de phase, constituées par les parties 150A des deuxièmes portions oxydées 150, résultent d'une seule étape d'oxydation de la couche semiconductrice 120. Par rapport à un procédé dans lequel les isolants électriques auraient été obtenus à des étapes différentes, ceci permet de réduire le nombre d'étapes de formation de ces isolants.

En outre, le procédé permet, en ne formant pas de premières portions oxydées dans la troisième portion, comme mentionné ci-dessus, que les contraintes 310L ne soient pas relâchées dans la direction de longueur des transistors contraints PMOS 610. Ceci permet d'avoir des contraintes mécaniques plus élevées dans la région de formation de canal de ces transistors PMOS, et peut ainsi permettre de meilleures performances des transistors PMOS. Ainsi, les transistors PMOS 610 ne sont pas isolés entre eux par des tranchées de type SSTI, et la troisième portion 210 forme une zone active continue, les transistors PMOS 610 pouvant être isolés entre eux par les grilles d'isolation 650.

De préférence, dans le cas où les portions semiconductrices 420C et 420D ont été prévues dans les régions respectives 520 et 530, ces portions sont dopées, à cette étape ou à une étape antérieure, d'un même type de conductivité (parmi les deux types N et P) que le substrat 110 ou qu'un caisson dopé formé sous l'isolant 130 sous les régions respectives 520 et 530. Dans le cas où des caissons (non représentés) sont formés sous les régions respectives 520 et 530, ces caissons peuvent être isolés électriquement entre eux grâce à la tranchée isolante 510A.

Chacune des portions semiconductrices 420C et 420D peut alors être surmontée d'une prise de contact, formant des zones de polarisation du substrat ("bulk strap", ou "bulk tap" en anglais). L'application d'un potentiel sur la prise de contact permet de polariser le substrat 110 ou le caisson sous la région 520, 530 concernée. Cette polarisation a pour rôle de contrôler électrostatiquement les transistors respectifs 610, 630, à travers l'isolant 130. Un tel contrôle est souhaitable, par exemple, pour modifier la tension de seuil des transistors 610, 630 en fonction d'un compromis recherché entre rapidité et consommation des transistors.

Comme indiqué plus avant, les portions semiconductrices 420C de la région 520 sont isolées de la troisième portion 210 par les parties 150C des deuxièmes portions oxydées 150, et les portions semiconductrices 420D de la région 530 sont isolées des quatrièmes portions 230 par les parties 150D des deuxièmes portions oxydées 150. Les deuxièmes portions oxydées 150 forment des isolations de type très peu profondes (SSTI), de sorte que des régions 111A et 111B, formant respectivement les caissons des transistors 610 et 630, peuvent être polarisées indépendamment car isolées les unes des autres par les tranchées isolantes 510A.

De préférence, on a formé, en même temps que les grilles 620, des grilles 620A (troisièmes grilles) sur les empilements 430. Dans le cas où des zones de contact électrique avec les régions d'émetteur, de base et/ou de collecteur des transistors bipolaires 545 sont formées, par exemple épitaxiées, sur les portions semiconductrices 420A, les grilles 620A permettent de former ces zones sans risquer que des ponts conducteurs non désirés se forment sur les empilements 430 et provoquent des courts circuits entre transistors bipolaires 545 voisins.

De préférence, dans la partie PW, on a formé en outre un transistor 660, ayant une grille 620B, dans et sur la portion semiconductrices 420B. Autrement dit, le transistor 660 a une région de formation de canal située dans une partie de la portion épitaxiée 420 située sous la grille 620B et séparée de la grille 620B par un isolant de grille non représenté. De préférence, le transistor 660 a une épaisseur d'isolant de grille supérieure à celle des transistors 610 et 630. Ceci permet au transistor 660 d'avoir une tension grille-source maximum (au-delà de laquelle le transistor pourrait être endommagé) supérieure à celle des transistors 610 et 620. La grille 620B est, de préférence, formée en même temps que les grilles 620 et 620A.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, on a décrit une puce électronique avec un circuit mémoire à changement de phase comprenant des points mémoire reliés à des transistors bipolaires, mais les modes de réalisation peuvent s'appliquer à d'autres puces électroniques, qui ne comprennent pas nécessairement de points d'une mémoire non volatile.

Enfin, la mise en oeuvre pratique des modes de réalisation et variantes décrits est à la portée de la personne du métier à partir des indications fonctionnelles données ci-dessus.

## Revendications

1. Procédé de fabrication d'une puce électronique (600), le procédé comprenant les étapes successives consistant à :
- prévoir une couche semiconductrice (120) située sur un isolant (130) recouvrant un substrat semiconducteur (110) ;
- oxyder des premières et deuxièmes portions de la couche semiconductrice jusqu'à l'isolant, de manière à former des premières portions oxydées (140) et des deuxièmes portions oxydées (150) sur l'isolant ;
- générer des contraintes (310) dans une troisième portion (210) de la couche semiconductrice non traversée par les premières et deuxièmes portions oxydées, la troisième portion s'étendant de manière continue entre les deuxièmes portions oxydées (150) ;
- former des cavités (410) s'étendant au moins jusqu'au substrat semiconducteur à travers les deuxièmes portions oxydées et l'isolant ; et
- former des premiers transistors à effet de champ (610) dans et sur la troisième portion (210).

2. Puce électronique (600) comprenant :
- des premières (140), deuxièmes (150) et troisième (210) portions d'une couche semiconductrice (120) située sur un isolant (130) recouvrant un substrat semiconducteur (110), les premières et deuxièmes portions de ladite couche semiconductrice étant oxydées jusqu'à l'isolant, la troisième portion (210) étant contrainte, n'étant pas traversée par les premières et deuxièmes portions oxydées, et s'étendant de manière continue entre des premières parties (150B) des deuxièmes portions oxydées ;
- des cavités (410) s'étendant au moins jusqu'au substrat semiconducteur à travers les deuxièmes portions oxydées et l'isolant ; et
- des premiers transistors (610) à effet de champ situés dans et sur la troisième portion (210).

3. Procédé selon la revendication 1 ou puce électronique selon la revendication 2, dans lequel :
- des quatrièmes portions (230) de la couche semiconductrice (120) sont formées à côté de la troisième portion (210), chaque quatrième portion étant entre deux des premières portions oxydées (140) ou entre une des premières portions oxydées et une des deuxièmes portions oxydées (150) ; et
- des deuxièmes transistors (630) à effet de champ sont formés dans et sur les quatrièmes portions.

4. Procédé selon la revendication 3, ou puce électronique selon la revendication 3, dans lequel des premières grilles (620) sont formées au-dessus des troisième et quatrièmes portions.

5. Procédé selon la revendication 3 ou 4, ou puce électronique selon la revendication 3 ou 4, dans lequel des deuxièmes grilles (625) sont formées au-dessus des premières portions oxydées (140) et des grilles d'isolation (650) sont formées dans la prolongation des deuxièmes grilles au-dessus de la troisième portion (210).

6. Procédé selon l'une quelconque des revendications 3 à 5, ou puce électronique selon l'une quelconque des revendications 3 à 5, dans lequel les quatrièmes portions (230) sont positionnées à côté de la troisième portion (210) dans la direction de la largeur des transistors à effet de champ.

7. Procédé selon l'une quelconque des revendications 3 à 6, ou puce électronique selon l'une quelconque des revendications 3 à 6, dans lequel les premiers transistors (610) sont à canal P contraint, et les deuxièmes transistors (630) sont à canal N, par exemple à canal N non contraint.

8. Procédé selon l'une quelconque des revendications 3 à 7, ou puce électronique selon l'une quelconque des revendications 3 à 7, dans lequel des tranchées isolantes (510) s'étendent à travers la couche semiconductrice (120) et l'isolant (130) jusqu'à un niveau situé à l'intérieur du substrat semiconducteur (110), les tranchées isolantes comprenant une première tranchée isolante (510A) entre la troisième portion (210) et les quatrièmes portions (230).

9. Procédé selon l'une quelconque des revendications 1, 3 à 8, ou puce électronique selon l'une quelconque des revendications 2 à 8, dans lequel la contrainte (310) de la troisième portion (210) résulte d'une modification de la composition de la couche semiconductrice (120) dans ladite troisième portion, par exemple comprend la formation d'une couche de silicium-germanium (230) sur la troisième portion, suivie d'un traitement thermique.

10. Procédé selon l'une quelconque des revendications 1 et 3 à 9, ou puce électronique selon l'une quelconque des revendications 2 à 9, dans lequel :
- les premières portions oxydées sont sensiblement parallèles entre elles, par exemple parallèles à la direction de la largeur des transistors à effet de champ ; et/ou
- les deuxièmes portions oxydées sont sensiblement parallèles entre elles, par exemple parallèles à la direction de la largeur des transistors à effet de champ ; et/ou
- les premières portions oxydées sont positionnées entre au moins deux des deuxièmes portions oxydées.

11. Procédé selon l'une quelconque des revendications 1 et 3 à 10, ou puce électronique selon l'une quelconque des revendications 2 à 10, dans lequel la couche semiconductrice (120) est une couche de silicium.

12. Procédé selon l'une quelconque des revendications 1 et 3 à 11, ou puce électronique selon l'une quelconque des revendications 2 à 11, dans lequel les premiers transistors (610) sont de type FDSOI.

13. Procédé selon l'une quelconque des revendications 1 et 3 à 12, ou puce électronique selon l'une quelconque des revendications 2 à 12, dans lequel des transistors bipolaires (545) sont formés dans au moins une première partie des cavités (410), et des points mémoire (640) à changement de phase reliés aux transistors bipolaires sont formés.

14. Procédé selon la revendication 13, ou puce électronique selon la revendication 13, dans lequel des zones semiconductrices dopées d'émetteur, de base et de collecteur des transistors bipolaires sont formées dans des premières portions semiconductrices épitaxiées (420A) dans la au moins une première partie des cavités (410).

15. Procédé selon la revendication 13 ou 14, ou puce électronique selon la revendication 13 ou 14, dans lequel des troisièmes grilles (620A) sont formées sur des deuxièmes parties (150A) des deuxièmes portions oxydées (150) entre les transistors bipolaires (545).

16. Procédé selon l'une quelconque des revendications 1 et 3 à 15, ou puce électronique selon l'une quelconque des revendications 2 à 15, dans lequel des transistors à effet de champ supplémentaires (660) sont formés dans et sur des deuxièmes portions semiconductrices épitaxiées (420B) dans une deuxième partie des cavités (410).

## Patentansprüche

1. Verfahren zum Herstellen eines elektronischen Chips (600), das die folgenden aufeinanderfolgenden Schritte aufweist:
- Bereitstellen einer Halbleiterschicht (120), die sich auf einem Isolator (130) befindet, der ein Halbleitersubstrat (110) bedeckt;
- Oxidieren eines ersten und eines zweiten Abschnitts der Halbleiterschicht bis zum Isolator, um einen ersten oxidierten Abschnitt (140) und einen zweiten oxidierten Abschnitt (150) auf dem Isolator auszubilden;
- Erzeugen einer Spannung (310) in einem dritten Abschnitt (210) der Halbleiterschicht, durch den der erste und der zweite oxidierte Abschnitt nicht verlaufen, wobei sich der dritte Abschnitt kontinuierlich zwischen den zweiten oxidierten Abschnitten (150) erstreckt;
- Ausbilden von Hohlräumen (410), die sich wenigstens bis zum Halbleitersubstrat durch die zweiten oxidierten Abschnitte und den Isolator erstrecken; und
- Ausbilden von ersten Feldeffekttransistoren (610) in und auf dem dritten Abschnitt (210).

2. Ein elektronischer Chip (600), der Folgendes aufweist:
- einen ersten (140), einen zweiten (150) und einen dritten (210) Abschnitt einer Halbleiterschicht (120), die sich auf einem Isolator (130) befindet, der ein Halbleitersubstrat (110) bedeckt, wobei der erste und der zweite Abschnitt der Halbleiterschicht bis zum Isolator oxidiert sind, der dritte Abschnitt (210) unter Spannung steht, nicht von dem ersten und dem zweiten oxidierten Abschnitt durchzogen ist und sich kontinuierlich zwischen ersten Teilen (150B) der zweiten oxidierten Abschnitte erstreckt;
- Hohlräume (410), die sich wenigstens bis zum Halbleitersubstrat durch die zweiten oxidierten Abschnitte und den Isolator erstrecken; und
- erste Feldeffekttransistoren (610), die sich in und auf dem dritten Abschnitt (210) befinden.

3. Das Verfahren nach Anspruch 1 oder der elektronische Chip nach Anspruch 2, wobei:
- vierte Abschnitte (230) der Halbleiterschicht (120) neben dem dritten Abschnitt (210) ausgebildet sind, wobei sich jeder vierte Abschnitt zwischen zwei der ersten oxidierten Abschnitte (140) oder zwischen einem der ersten oxidierten Abschnitte und einem der zweiten oxidierten Abschnitte (150) befindet; und
- zweite Feldeffekttransistoren (630) in und auf den vierten Abschnitten ausgebildet werden.

4. Das Verfahren nach Anspruch 3 oder der elektronische Chip nach Anspruch 3, wobei erste Gates (620) über den dritten und vierten Abschnitten ausgebildet werden.

5. Das Verfahren nach Anspruch 3 oder 4 oder der elektronische Chip nach Anspruch 3 oder 4, wobei zweite Gates (625) über den ersten oxidierten Abschnitten (140) ausgebildet sind und isolierende Gates (650) in einer Linie mit den zweiten Gates über dem dritten Abschnitt (210) ausgebildet sind.

6. Das Verfahren nach einem der Ansprüche 3 bis 5 oder der elektronische Chip nach einem der Ansprüche 3 bis 5, wobei die vierten Abschnitte (230) neben dem dritten Abschnitt (210) in der Breitenrichtung der Feldeffekttransistoren positioniert sind.

7. Das Verfahren nach einem der Ansprüche 3 bis 6 oder der elektronische Chip nach einem der Ansprüche 3 bis 6, wobei die ersten Transistoren (610) einen belasteten P-Kanal und die zweiten Transistoren (630) einen N-Kanal, beispielsweise einen unbelasteten N-Kanal, aufweisen.

8. Das Verfahren nach einem der Ansprüche 3 bis 7 oder der elektronische Chip nach einem der Ansprüche 3 bis 7, wobei sich Isolationsgräben (510) durch die Halbleiterschicht (120) und den Isolator (130) bis zu einer Ebene erstrecken, die sich innerhalb des Halbleitersubstrats (110) befindet, wobei die Isolationsgräben einen ersten Isolationsgraben (510A) zwischen dem dritten Abschnitt (210) und den vierten Abschnitten (230) aufweisen.

9. Das Verfahren nach einem der Ansprüche 1, 3 bis 8 oder der elektronische Chip nach einem der Ansprüche 2 bis 8, wobei die Spannung (310) des dritten Abschnitts (210) aus einer Änderung der Zusammensetzung der Halbleiterschicht (120) in dem dritten Abschnitt resultiert, beispielsweise aufweisend das Ausbilden einer Silizium-Germanium-Schicht (230) auf dem dritten Abschnitt, gefolgt von einer thermischen Behandlung.

10. Das Verfahren nach einem der Ansprüche 1 und 3 bis 9 oder der elektronische Chip nach einem der Ansprüche 2 bis 9, wobei:
- die ersten oxidierten Abschnitte im Wesentlichen parallel zueinander sind, beispielsweise parallel zur Breitenrichtung der Feldeffekttransistoren; und/oder
- die zweiten oxidierten Abschnitte im Wesentlichen parallel zueinander sind, beispielsweise parallel zur Breitenrichtung der Feldeffekttransistoren; und/oder
- die ersten oxidierten Abschnitte zwischen wenigstens zwei der zweiten oxidierten Abschnitte positioniert sind.

11. Das Verfahren nach einem der Ansprüche 1 und 3 bis 10 oder der elektronische Chip nach einem der Ansprüche 2 bis 10, wobei die Halbleiterschicht (120) eine Siliziumschicht ist.

12. Das Verfahren nach einem der Ansprüche 1 und 3 bis 11 oder der elektronische Chip nach einem der Ansprüche 2 bis 11, wobei die ersten Transistoren (610) vom Typ FDSOI sind.

13. Das Verfahren nach einem der Ansprüche 1 und 3 bis 12 oder der elektronische Chip nach einem der Ansprüche 2 bis 12, wobei Bipolartransistoren (545) in wenigstens einem ersten Teil der Hohlräume (410) ausgebildet sind und Phasenwechsel-Speicherzellen (640) ausgebildet sind, die mit den bipolaren Transistoren gekoppelt sind.

14. Das Verfahren nach Anspruch 13 oder der elektronische Chip nach Anspruch 13, wobei dotierte Emitter-, Basis- und Kollektor-Halbleiterbereiche der Bipolartransistoren in ersten epitaktischen Halbleiterabschnitten (420A) in dem wenigstens einen ersten Teil der Hohlräume (410) ausgebildet sind.

15. Das Verfahren nach Anspruch 13 oder 14 oder der elektronische Chip nach Anspruch 13 oder 14, wobei dritte Gates (620A) auf zweiten Teilen (150A) der zweiten oxidierten Abschnitte (150) zwischen den Bipolartransistoren (545) ausgebildet sind.

16. Das Verfahren nach einem der Ansprüche 1 und 3 bis 15 oder der elektronische Chip nach einem der Ansprüche 2 bis 15, wobei zusätzliche Feldeffekttransistoren (660) in und auf zweiten epitaktischen Halbleiterabschnitten (420B) in einem zweiten Teil der Hohlräume (410) ausgebildet sind.

## Claims

1. A method of manufacturing an electronic chip (600), the method comprising the successive steps of:
- providing a semiconductor layer (120) located on an insulator (130) covering a semiconductor substrate (110);
- oxidizing first and second portions of the semiconductor layer down to the insulator, to form first oxidized portions (140) and second oxidized portions (150) on the insulator;
- generating stress (310) in a third portion (210) of the semiconductor layer through which the first and second oxidized portions do not pass, the third portion extending continuously between the second oxidized portions (150);
- forming cavities (410) extending at least down to the semiconductor substrate through the second oxidized portions and the insulator; and
- forming first field-effect transistors (610) in and on top of the third portion (210).

2. An electronic chip (600) comprising:
- first (140), second (150), and third (210) portions of a semiconductor layer (120) located on an insulator (130) covering a semiconductor substrate (110), the first and second portions of said semiconductor layer being oxidized down to the insulator, the third portion (210) being stressed, not having the first and second oxidized portions passing through it, and continuously extending between first parts (150B) of the second oxidized portions;
- cavities (410) extending at least down to the semiconductor substrate through the second oxidized portions and the insulator; and
- first field-effect transistors (610) located in and on top of the third portion (210).

3. The method according to claim 1 or the electronic chip according to claim 2, wherein:
- fourth portions (230) of the semiconductor layer (120) are formed next to the third portion (210), each fourth portion being between two of the first oxidized portions (140) or between one of the first oxidized portions and one of the second oxidized portions (150); and
- second field-effect transistors (630) are formed in and on top of the fourth portions.

4. The method according to claim 3, or the electronic chip according to claim 3, wherein first gates (620) are formed above the third and fourth portions.

5. The method according to claim 3 or 4, or the electronic chip according to claim 3 or 4, wherein second gates (625) are formed above the first oxidized portions (140) and insulating gates (650) are formed in line with the second gates above the third portion (210).

6. The method according to any of claims 3 to 5, or the electronic chip according to any of claims 3 to 5, wherein the fourth portions (230) are positioned next to the third portion (210) in the width direction of the field-effect transistors.

7. The method according to any of claims 3 to 6, or the electronic chip according to any of claims 3 to 6, wherein the first transistors (610) have a stressed P channel, and the second transistors (630) have an N channel, for example an unstressed N channel.

8. The method according to any of claims 3 to 7, or the electronic chip according to any of claims 3 to 7, wherein insulating trenches (510) extend through the semiconductor layer (120) and the insulator (130) down to a level located within the semiconductor substrate (110), the insulating trenches comprising a first insulating trench (510A) between the third portion (210) and the fourth portions (230).

9. The method according to any of claims 1, 3 to 8, or the electronic chip according to any of claims 2 to 8, wherein the stress (310) of the third portion (210) results from a change in the composition of the semiconductor layer (120) in said third portion, for example comprising the forming of a silicon-germanium layer (230) on the third portion, followed by a thermal treatment.

10. The method according to any of claims 1 and 3 to 9, or the electronic chip according to any of claims 2 to 9, wherein:
- the first oxidized portions are substantially parallel to one another, for example parallel to the width direction of the field-effect transistors; and/or
- the second oxidized portions are substantially parallel to one another, for example parallel to the width direction of the field-effect transistors; and/or
- the first oxidized portions are positioned between at least two of the second oxidized portions.

11. The method according to any of claims 1 and 3 to 10, or the electronic chip according to any of claims 2 to 10, wherein the semiconductor layer (120) is a silicon layer.

12. The method according to any of claims 1 and 3 to 11, or the electronic chip according to any of claims 2 to 11, wherein the first transistors (610) are of FDSOI type.

13. The method according to any of claims 1 and 3 to 12, or the electronic chip according to any of claims 2 to 12, wherein bipolar transistors (545) are formed in at least a first part of the cavities (410), and phase-change memory cells (640) coupled to the bipolar transistors are formed.

14. The method according to claim 13, or the electronic chip according to claim 13, wherein doped emitter, base, and collector semiconductor regions of the bipolar transistors are formed in first epitaxial semiconductor portions (420A) in the at least first part of the cavities (410) .

15. The method according to claim 13 or 14, or the electronic chip according to claim 13 or 14, wherein third gates (620A) are formed on second parts (150A) of the second oxidized portions (150) between the bipolar transistors (545) .

16. The method according to any of claims 1 and 3 to 15, or the electronic chip according to any of claims 2 to 15, wherein additional field-effect transistors (660) are formed in and on top of second epitaxial semiconductor portions (420B) in a second part of the cavities (410).
